# EUROPÄISCHE PATENTSCHRIFT

(11) **EP 3 699 704 B1**
(45) Veröffentlichungstag und Bekanntmachung des Hinweises auf die Patenterteilung: **27.10.2021**
(21) Anmeldenummer: 19158513.2
(22) Anmeldetag: 21.02.2019
(51) Int. Cl.: G05B 19/418

(54) **SYSTEM UND VERFAHREN ZUM ÜBERPRÜFEN VON SYSTEMANFORDERUNGEN VON CYBER-PHYSIKALISCHEN SYSTEMEN**
SYSTEM AND METHOD FOR VALIDATING SYSTEM REQUIREMENTS OF CYBER-PHYSICAL SYSTEMS
SYSTÈME ET PROCÉDÉ DE VÉRIFICATION DES EXIGENCES DU SYSTÈME DES SYSTÈMES CYBER-PHYSIQUES

(43) Veröffentlichungstag der Anmeldung: 26.08.2020
(73) Patentinhaber: Siemens Aktiengesellschaft, 80333 München (DE)
(72) Erfinder: Böhm, Birthe, 90480 Nürnberg (DE)

(56) Entgegenhaltungen:
- DE-A1-102016 224 457
- ZHUANG CUNBO ET AL: "Digital twin-based smart production management and control framework for the complex product assembly shop-floor", THE INTERNATIONAL JOURNAL OF ADVANCED MANUFACTURING TECHNOLOGY, SPRINGER, LONDON, Bd. 96, Nr. 1, 7. Februar 2018 (2018-02-07), Seiten 1149-1163, XP036468995, ISSN: 0268-3768, DOI: 10.1007/S00170-018-1617-6 [gefunden am 2018-02-07]
- STARK RAINER ET AL: "Development and operation of Digital Twins for technical systems and services", CIRP ANNALS, ELSEVIER BV, NL, CH, FR, Bd. 68, Nr. 1, 1. Januar 2019 (2019-01-01) , Seiten 129-132, XP085731372, ISSN: 0007-8506, DOI: 10.1016/J.CIRP.2019.04.024

## Beschreibung

Die Erfindung betrifft ein Verfahren zum Überprüfen von Systemanforderungen von cyber-physikalischen Systemen in einem Systemverbund.

Die Erstellung von modernen automatisierten Anlagen, wie zum Beispiel Produktionszellen in der Automobilindustrie oder in jeder beliebigen anderen Produktionsanlage, basiert auf dem Konzept von cyber-physikalischen Systemen (engl. cyber-physical systems). Ein cyber-physikalisches System bezeichnet den Verbund informatischer, softwaretechnischer Komponenten mit mechanischen und elektronischen Elementen, die über eine Dateninfrastruktur, wie zum Beispiel WLAN, LAN und/oder das Internet, kommunizieren und ist durch einen hohen Grad an Komplexität gekennzeichnet. Die Ausbildung von cyber-physikalischen Systemen entsteht aus der Vernetzung eingebetteter Systemkomponenten durch drahtgebundene oder drahtlose Kommunikationsnetze. Cyber-physikalische Systeme decken ein breites Spektrum möglicher Bereiche ab, in denen sie zum Einsatz kommen können. Hierzu gehören medizintechnische Geräte und Systeme, Verkehrssteuerungs- und Verkehrs-Logistiksysteme, vernetzte Sicherheits- sowie Fahrassistenz-Systeme im Automobilbereich, industrielle Produktionszellen in der Fertigung, Energieversorgungsmanagementsysteme, Infrastruktursysteme für Telekommunikation, etc.

Das Design von cyber-physikalischen Systemen erfordert die Integration von unterschiedlichen Komponenten auf verschiedenen Ebenen zu einem Gesamtsystem. Zu nennen sind die physikalische und elektrische Ebene, dann gibt es netzwerktechnische Anforderungen, des Weiteren ist eine Ereignis- und Datenflussintegration erforderlich, weiterhin sind physikalisch-prozessuale Anforderungen zu beachten und außerdem sind die einzelnen Komponenten in eine Steuerungshierarchie (engl. control hierarchy) einzubetten.

Bei der Konzeption und Entwicklung (Engineering) industrieller Anlagen sind daher eine Vielzahl von Aufgabenbereichen zu berücksichtigen, wie beispielsweise Fragen der Elektrik, Automatisierung, Verfahrenstechnik und Mechanik. Dabei werden teilweise Entwicklungsarbeiten parallel durchgeführt, andererseits bauen die Arbeiten auch aufeinander auf. Normalerweise gibt es eine gemeinsame Basis für das Engineering wie beispielsweise das Konzept, die Anforderungen, das Layout bzw. ein Rohrleitungs- und Instrumentendiagramm und eine Vielzahl von wechselseitigen Abhängigkeiten zwischen den Aufgabenbereichen. Dabei ist die Erhaltung der Qualität sowie der Schlüssigkeit und der Konsistenz der Engineering-Lösung über alle Aufgabenbereiche hinweg spätestens dann schwierig, sobald Änderungen an der gemeinsamen Basis durchgeführt werden oder aufgabenspezifische Entscheidungen getroffen werden, die Einflüsse auf andere Bereiche haben. Häufig ist weder klar, wer über diese Entscheidungen zu informieren ist, noch welche Änderungen tatsächlich relevant für andere Bereiche sind. Daher erfolgt oft keine Information der anderen Bereiche oder relevante Änderungen in einem Bereich werden insgesamt nicht zur Kenntnis genommen, da sie in einer Vielzahl von Informationen über irrelevante Änderungen enthalten sind und diese Informationsmitteilungen oft ohne Struktur und Hinweisen zu ihrer Bedeutung verteilt werden.

Relevante unentdeckte Änderungen können aber zu weitreichenden Problemen im Verlauf eines Projektes führen. Häufig werden solche Änderungen jedoch erst in der Inbetriebsetzungsphase aufgrund entstehender Probleme bei der Integration der verschiedenen Aufgabenbereiche entdeckt und führen dementsprechend oft zu hohen Kosten und Verzögerungen des Fertigstellungstermins.

Allgemein gilt, dass eine möglichst frühzeitige Information über relevante Änderungen anzustreben ist. Dabei ist allerdings auch darauf zu achten, dass möglichst nur die relevanten Änderungen tatsächlich bereichsübergreifend weitergegeben werden, um den Aufwand zur Erfassung der Änderungen für das gesamte Projekt möglichst gering zu halten.

Darüber hinaus treten Änderungen bei der Konzeption und Entwicklung von industriellen Anlagen sehr häufig auf und lassen sich häufig aufgrund der Komplexität der Projekte auch nicht vermeiden. Die Festlegung eines Konzepts (Design Freeze) innerhalb von Engineering-Projekten ermöglicht eine stabile Basis für die darauf aufbauenden und nachfolgenden Arbeiten. Allerdings ergeben sich im Laufe eines Projekts wie der Erstellung einer industriellen Anlage immer wieder Änderungen auch an dieser Basis, die dann entsprechend in den verschiedenen Aufgabenbereichen umgesetzt werden müssen.

Daher sind auch Änderungen nach der Festlegung des Gesamtkonzepts (Design Freeze) üblicherweise notwendig. Daneben können auch Fehler bei der Konzepterstellung auftreten, die ebenfalls Auswirkungen auf die Struktur und Qualität der Engineering-Lösung haben.

Derzeit gibt es für diese Problemstellung die folgenden Lösungsansätze: Eine aufgabenübergreifende Systemarchitektur gewährleistet den grundsätzlichen logischen und inhaltlichen Zusammenhang zwischen den verschiedenen Aufgabenbereichen. Des Weiteren wird eine stetige Überprüfung des Konzepts innerhalb der einzelnen Aufgabenbereiche, aber auch bereichsübergreifend angestrebt, um die erforderliche Qualitätssicherung zu erreichen.

Dafür werden sogenannte Engineering-Werkzeuge eingesetzt, die Änderungen in der Engineering-Lösung dokumentieren und gegebenenfalls Projektmitarbeiter über erfolgte Änderungen informieren. Engineering-Werkzeuge sind Software-Werkzeuge, die im Engineering eingesetzt werden, beispielsweise für ausgewählte Aufgaben im Bereich der Elektrik, Automatisierung, und Instrumentierung.

Dies setzt allerdings voraus, dass eine integrierte Werkzeuglandschaft vorliegt, so dass alle Änderungen zwischen den Bereichen ausgetauscht werden können. Dies ist jedoch derzeit nicht für alle beteiligten Arbeitsbereiche verwirklicht oder es sind unterschiedliche Subunternehmen an einem Projekt beteiligt, die wiederum unterschiedliche Engineering-Werkzeuge verwenden. Daher kann derzeit davon ausgegangen werden, dass eine durchgängige Integration über alle Subunternehmen und alle Arbeitsbereiche nicht gegeben ist.

Grundsätzlich ist es auch möglich, durch eine enge Zusammenarbeit aller Arbeitsbereiche Informationen über Design- und Konzeptentscheidungen oder Änderungen persönlich zwischen den Experten für die jeweiligen Arbeitsbereiche weiterzugeben. Allerdings sind die Auswirkungen von Änderungen auf andere Arbeitsbereiche, wie Änderung bei der Elektrik auf die Mechanik, technisch häufig nur schwierig einschätzbar und zudem ist zwischen den einzelnen Mitarbeitern und Experten der verschiedenen Bereiche eine erhebliche Kommunikationsbereitschaft erforderlich, die bekanntlich nicht immer vorhanden ist.

Sogenannte Änderungskontrollgremien (Change Control Board) können die Relevanz von Änderungen bewerten. Änderungskontrollgremien sind üblicherweise mit Experten der unterschiedlichen Arbeitsbereiche besetzt, besprechen gemeinsam Änderungen und entscheiden über die weitere Vorgehensweise. Aufgrund des Aufwands werden jedoch üblicherweise nur offensichtlich weitreichende Änderungen besprochen. Oft liegt der Fokus auch auf Änderungen, die durch den Kunden des Projektes angestoßen oder gefordert werden, häufig mit der Zielsetzung, die Kosten zu senken. Die Besprechung aller Änderungen ist aufwändig und in einem solchen Rahmen kaum möglich.

Daher stellt die bereichsübergreifende Qualitätssicherung sowie der logische Zusammenhang und die Konsistenz eines Engineering-Konzepts sowie Änderungen im Engineering während der Umsetzungsphase immer noch ein großes Problem dar, insbesondere, wenn Inkonsistenzen aufgrund von Änderungen erst in der Inbetriebsetzungsphase auffallen. Verhältnismäßig lang andauernde Inbetriebsetzungsphasen dienen daher häufig auch der Beseitigung von Inkonsistenzen und Qualitätsmängeln. Dabei kann es zu weiteren Änderungen kommen, die entweder direkt vor Ort durchgeführt werden können oder andere weitreichendere Lösungsansätze erfordern.

Engineering-Lösungen können auf Basis weitgehend autonomer und intelligenter Systeme erstellt werden. Die Grundidee ist hier, dass sich diese cyber-physikalischen Systeme zur Erfüllung einer Aufgabe zu einem Systemverbund zusammenschließen. Beispielsweise kann eine industrielle Anlage als Systemverbund autonomer, intelligenter cyber-physikalischer Systeme wie beispielsweise Produktionszellen, Stationen innerhalb einer Fertigungslinie und Maschinen konzipiert sein, wie dies im Allgemeinen in Industrie 4.0-Szenarien angenommen wird. Auch die Produktionszellen selbst können bereits einen Verbund von autonomen, intelligenten Systemen darstellen, wie beispielsweise Motoren, Förderbänder, Roboterarme und Werkzeuge. Diskutiert wird dabei der Einsatz eines "digitalen Zwillings" (Digital Twin), der den Zustand solcher Systeme simuliert und daraus Auswertungen bezüglich des Zustands des Systems ermöglicht sowie einen digitalen Repräsentanten dieser cyber-physikalischen Systeme darstellt.

Es ist üblich, bei einer solche Vorgehensweise einen digitalen Zwilling für diese Systeme bereits in der Konzeptions-Phase zu entwickeln, da in dieser Entwurfsphase typischerweise noch nicht alle Systeme tatsächlich physisch vorhanden sind. Der physische Aufbau der Anlage beginnt normalerweise erst am Ende der Entwurfsphase, dabei kann der jeweilige digitale Zwilling dann entsprechend seinem physischen Zwilling zugeordnet werden und ihn über den gesamten Lebenszyklus begleiten.

Allerdings gibt es bisher keine zufriedenstellende Lösung, die Verfahren der künstlichen Intelligenz wie den Einsatz eines digitalen Zwillings bereits in der Planungsphase von cyber-physikalischen Systemen einzusetzen, um widersprüchliche oder inkonsistente Systemanforderungen insbesondere durch Änderungen des Basiskonzepts zu erkennen. Bisher findet eine Bewertung auf Basis der aktuellen Konfiguration bzw. des aktuellen Zustands eines cyber-physikalischen Systems statt und dann ist es häufig sehr aufwendig, Korrekturen durchzuführen.

Zhuang Cunbo ET AL: "Digital twin-based smart production management and control framework for the complex product assembly shop-floor" zeigt einen Ansatz für ein digitales, zweistufiges, intelligentes Produktionsmanagement- und Steuerungskonzept für komplexe Produktionsstätten vor. Es erfolgt eine Echtzeit-Erfassung, Organisation und Verwaltung der physischen Daten der Montagehalle. Es wird ein digitaler Zwilling der Montagehalle erstellt. Es erfolgt eine digitale Zwillings- und Großdaten-gesteuerte Vorhersage der Montagehalle, sowie ein digitales Zwillingsmontage-Produktionsmanagement und Controlling.

Die der Erfindung zu Grunde liegende Aufgabe besteht nun darin, ein System und ein Verfahren zur Überprüfung von Systemanforderungen von cyber-physikalischen Systemen anzugeben, das sich durch eine hohe Zuverlässigkeit und Sicherheit auszeichnet und eine verbesserte Ressourcenplanung und - auslastung und damit eine Optimierung in der Planungsphase von cyber-physikalischen Systemen auszeichnet, aber auch während der Umsetzungsphase und im Betrieb des cyber-physikalischen Systems eine verbesserte Erkennung von Inkonsistenzen ermöglicht.

Diese Aufgabe wird durch ein Verfahren mit den im Patentanspruch 1 angegebenen Merkmalen sowie durch ein System mit im Patentanspruch 6 angegebenen Merkmalen gelöst.

Die weiteren Patentansprüche betreffen bevorzugte Ausgestaltungen der Erfindung.

Die Erfindung betrifft gemäß einem ersten Aspekt ein Verfahren zum Überprüfen von Systemanforderungen von cyber-physikalischen Systemen in einem Systemverbund, umfassend die Merkmale des Patentanspruchs 1.

Gemäß dem ersten Aspekt der Erfindung weisen die digitalen Zwillinge jeweils einen Engineering-Anteil auf, mit dem das Engineering des zugehörigen cyber-physikalischen Systems durchgeführt wird.

In einer weiteren Ausgestaltung wird ein digitaler Zwilling für einen Systemverbund aus den cyber-physikalischen System erstellt und die digitalen Zwillinge der cyber-physikalischen Systeme werden mit dem digitalen Zwilling für den Systemverbund verknüpft.

Vorteilhafterweise teilt der digitale Zwilling, bei dessen zugeordnetem cyber-physikalischem System eine Änderung einer Systemanforderung auftritt, diese Änderung den anderen mit ihm verknüpften Zwillingen mit, und diese Zwillinge vergleichen die geänderte Systemanforderung mit den bisher vorliegenden Systemanforderungen.

In einer weiteren Ausgestaltung wird jede Änderung einer Systemanforderung mit einer Identitätskennung versehen. Vorteilhafterweise kommunizieren die digitalen Zwillinge über eine Kommunikationsschnittstelle mit den anderen digitalen Zwillingen.

Gemäß dem ersten Aspekt der Erfindung sind die ursprünglichen Systemanforderungen der digitalen Zwillinge gespeichert und beim Entfernen eines digitalen Zwillings aus einem Systemverbund können die verbleibenden digitalen Zwillinge auf ihre ursprünglichen Systemanforderungen zurückgreifen.

Die Erfindung betrifft gemäß einem zweiten Aspekt ein System zum Überprüfen von Systemanforderungen von cyber-physikalischen Systemen in einem Systemverbund mit den Merkmalen des Patentanspruchs 6.

Gemäß dem zweiten Aspekt der Erfindung weisen die digitalen Zwillinge jeweils einen Engineering-Anteil auf, mit dem das Engineering des zugehörigen cyber-physikalischen Systems durchführbar ist.

Vorteilhafterweise ist ein digitaler Zwilling für einen Systemverbund der cyber-physikalischen Systeme vorgesehen und die digitalen Zwillinge der cyber-physikalischen Systeme sind mit dem digitalen Zwilling für den Systemverbund verknüpft.

In einer weiteren Ausgestaltung ist der digitale Zwilling, bei dessen zugeordnetem cyber-physikalischem System eine Änderung einer Systemanforderung auftritt, ausgebildet, diese Änderung den anderen mit ihm verknüpften Zwillingen mitzuteilen und diese Zwillinge sind ausgebildet, die geänderte Systemanforderung mit den bisher vorliegenden Systemanforderungen zu vergleichen.

Vorteilhafterweise ist jede Änderung einer Systemanforderung mit einer Identitätskennung versehen.

In einer vorteilhaften Weiterentwicklung weisen die digitalen Zwillinge eine Kommunikationsschnittstelle zur Kommunikation mit anderen digitalen Zwillingen auf.

Gemäß dem zweiten Aspekt der Erfindung sind die ursprünglichen Systemanforderungen der digitalen Zwillinge gespeichert und beim Entfernen eines digitalen Zwillings aus einem Systemverbund können die verbleibenden digitalen Zwillinge auf ihre ursprünglichen Systemanforderungen zurückgreifen.

Die Erfindung betrifft gemäß einem dritten Aspekt ein Computerprogrammprodukt, das einen und/der mehrere ausführbare Computercodes enthält zur Ausführung des Verfahrens nach einem oder mehreren der Ansprüche 1 bis 5.

Nachfolgend wird die Erfindung anhand von in der Zeichnung dargestellten Ausführungsbeispielen näher erläutert.

Dabei zeigt:
- Figur 1: eine Übersichtsdarstellung zur Erläuterung eines erfindungsgemäßen Systems;
- Figur 2: ein Blockdiagramm zur Erläuterung eines Ausführungsdetails des erfindungsgemäßen Systems;
- Figur 3: ein Blockdiagramm zur Erläuterung eines weiteren Ausführungsdetails des erfindungsgemäßen Systems;
- Figur 4: ein Blockdiagramm zur Erläuterung eines weiteren Ausführungsdetails des erfindungsgemäßen Systems;
- Figur 5: ein Ablaufdiagramm zur Erläuterung eines Verfahrens gemäß der Erfindung;
- Figur 6: eine schematische Darstellung eines Computerprogrammproduktes gemäß der Erfindung.

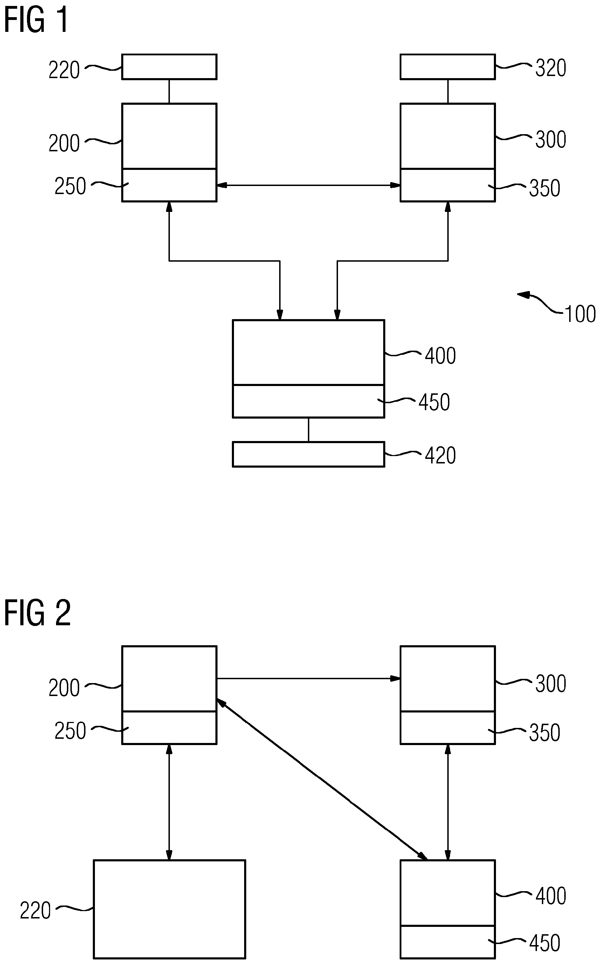

Zusätzliche Merkmale, Aspekte und Vorteile der Erfindung oder ihrer Ausführungsbeispiele werden durch die ausführliche Beschreibung in Verbindung mit den Ansprüchen ersichtlich. Fig 1 zeigt ein System 100 mit drei digitalen Zwillingen 200. 300. 400. Jeder der digitalen Zwillinge 200, 300, 400 stellt ein digitales Spiegelbild eines cyber-physikalischen Systems 220, 320, 320 dar und wird vor allem für die Nutzung von Simulationsmodellen zur Ablaufoptimierung des Betriebes des jeweiligen cyber-physikalischen Systems 220, 320, 420 wie einer Industrieanlage eingesetzt.

Des Weiteren enthält jeder digitaler Zwilling 200, 300, 400 einen Engineering-Anteil 250, 350, 450, der für das Engineering des cyber-physikalischen Systems 220, 320, 420 und den Zusammenschluss der mehreren cyber-physikalischen Systeme 220, 320, 420 zu einem Systemverbund verwendet werden kann. Dieser Engineering-Anteil enthält alle Engineering-Informationen, die das cyber-physikalische System betreffen einschließlich einer Dokumentation, damit das cyber-physikalische System in einer Engineeringlösung wie einem Systemverbund, beispielsweise eine Fertigungsanlage, verwendet werden kann. Wird das cyber-physikalische System in einen Systemverbund integriert, dann stellt das cyber-physikalische System seine Schnittstellen zur Verfügung, beispielsweise die Art der elektrischen Anschlüsse, Rohrleitungsanschlüsse etc. sowie seine Dokumentation. In einem cyber-physikalischen Systemverbund können dann unterschiedliche cyber-physikalische Systeme über die gegenseitige Nutzung von Schnittstellen integriert werden.

Dabei werden vorzugsweise Engineering-Werkzeuge eingesetzt. Alle Informationen über ein cyber-physikalisches System 220, 320, 420 können damit in dem jeweiligen digitalen Zwilling 200, 300, 400 gespeichert und gebündelt werden. Insbesondere können sowohl Anforderungen des cyber-physikalischen Systems 220, 320, 420 an seine Umgebung bzw. Randbedingungen zur Nutzung des Systems 220, 320, 420 oder bestimmte Eigenschaften explizit dokumentiert werden. Solche Anforderungen an die Umgebung oder Eigenschaften können Umweltbedingungen beinhalten, wie beispielsweise Temperaturbereiche, innerhalb derer das cyber-physikalische System 220, 320, 420 zuverlässig arbeitet. Ein anderes Beispiel stellt die Erdbebensicherheit eines cyber-physikalischen Systems 220, 320, 420 dar. Daneben sind technische Anforderungen wie z.B. die elektrische Spannungsebene, benötigte Spezifikationen von elektrischen und mechanischen Anschlüssen wie beispielsweise anzuschließende Rohrleitungen, die Nutzung bestimmter Datenformate für die Datenübertragung, die Abhängigkeiten zu anderen cyber-physikalischen Systemen 220, 320, 420 im Systemverbund (z.B. benötigt ein System 220, 320, 420 Kenntnis von der Umgebungstemperatur durch einen externen Temperatursensor) von Bedeutung.

Die Dokumentation dieser Systemanforderungen erfolgt mittels einer maschinenlesbaren Sprache. Diese kann beispielsweise wie folgt umgesetzt werden:
Temp_min = 4 °C
Temp_max = 30 °C
Data_Format = ASCII

Für eine solche Dokumentation ist eine allgemeine Definition der Schlüsselworte und ihrer Wertebereiche, beispielsweise mittels der Nutzung einer Ontologie, erforderlich.

In Fig. 2 ist von den drei digitalen Zwillingen 200, 300, 400 der Zwilling 200 bereits mit einem real existierenden cyberphysischen System 220 verbunden. Dieser digitale Zwilling 200 kann Entscheidungen bezüglich des cyber-physikalischen Systems 220 treffen. Da er in Verbindung mit den anderen digitalen Zwillingen 300, 400 steht, kann eine Entscheidung auch in Absprache mit den anderen beiden Zwillingen 300, 400 erfolgen.

Gemäß der vorliegenden Erfindung wird durch die Kommunikation der digitalen Zwillinge 200, 300, 400 miteinander, eine Unterstützung bei der Erstellung eines in sich schlüssigen Anlagenkonzepts sowie bei der Bewertung der Relevanz von Änderungen innerhalb eines cyber-physikalischen Systems 220 und deren Auswirkungen auf verbundene cyber-physikalische Systeme 320, 420 ermöglicht.

Die Kommunikation der digitalen Zwillinge 200, 300, 400 untereinander kann beispielsweise über generisch definierte, allgemeine Schnittstellen erfolgen, die einerseits die Abfrage der Anforderungen eines cyber-physikalischen Systems 220, 320, 420 und andererseits das Mitteilen von Anforderungen und deren Wertebetrag durch die Verbreitung an andere digitale Zwillinge 200, 300, 400 erlaubt. Im Folgenden ist ein Beispiel dargestellt:
Lese Anforderung (<Name der Anforderung>)

### Verbreite Anforderung (<Identität der Verbreitung>, <Name der Anforderung>, <Wert der Anforderung>)

Dieses Verfahren kann auch bei Änderungen der Anforderungen eingesetzt werden. Insbesondere kann das Erstellen einer Engineering-Lösung bereits als eine Abfolge von Änderungen betrachtet werden. Im Falle einer späteren Änderung der Engineering-Lösung ist dann das zugrundliegende Verfahren der Kommunikation der digitalen Zwillinge 200, 300, 400 untereinander unverändert.

In einer Weiterentwicklung der Erfindung ist vorgesehen, dass in Engineering-Werkzeugen die digitalen Zwillinge 200, 300, 400 bereichspezifisch miteinander verknüpft werden. Jeder Arbeitsbereich kann in dem digitalen Zwilling 200, 300, 400 die jeweils ihn betreffenden Systemanforderungen definieren. Den Systemanforderungen können Engineering-Bereiche und/oder Zuständigkeiten zugeordnet werden. In einer Softwareapplikation können dann den Engineering-Bereichen und/oder Zuständigkeiten Personen zugeordnet werden, die im Falle einer Inkonsistenz zu informieren sind. Dies stellt sicher, dass die Inkonsistenzen zielgerichtet den zuständigen Personen angezeigt werden.

Diese Überprüfungen erfolgen durch Verknüpfungen der digitalen Zwillinge 200, 300, 400 miteinander. Dabei überprüfen die digitalen Zwillinge 200, 300, 400 wechselseitig ihre Anforderungen, die in dem Engineering-Anteil 250, 350, 450 gespeichert sind. So kann der digitale Zwilling 200 die mit ihm verknüpften digitalen Zwillinge 300, 400 jeweils nach ihren Anforderungen befragen und diese Anforderungen mit den eigenen Anforderungen vergleichen und/oder seine Anforderungen den anderen Zwillingen 300, 400 jeweils mitteilen. Hat einer der anderen digitalen Zwillinge 300, 400 eingeschränktere Anforderungen, dann kann der digitale Zwilling 200 seine Anforderungen vorzugsweise derart anpassen, dass sie mit den Anforderungen der anderen digitalen Zwillinge 300, 400 kongruent sind und gibt diese neuen angepassten Anforderungen an die anderen Zwillinge 300, 400 weiter. Sind die Anforderungen des digitalen Zwillings 200 selbst eingeschränkter, so gibt er seine eigenen Anforderungen zum Abgleich an die jeweils verknüpften digitale Zwillinge 300, 400 weiter. Dabei ist es auch möglich, dass nur mit einer Teilmenge der Zwillinge 300, 400 ein Abgleich stattfindet.

Beispielsweise kann für das cyber-physikalische System 220 ein Temperaturbereich von 0 - 50 °C vorgesehen sein, in dem dieses System 220 arbeitsfähig sein soll, während für das cyber-physikalische System 320 ein Temperaturbereich von 10 - 20°C bestimmt ist. Der Systemverbund aus beiden cyber-physikalischen Systemen 220, 320 könnte dann in einem Temperaturbereich von 10 - 20 °C arbeiten. Dem cyber-physikalischen System 220 ist der digitale Zwilling 200 zugeordnet, während das cyber-physikalische System 320 durch den digitalen Zwilling 300 abgebildet wird. Der digitale Zwilling 200 gleicht somit seinen Temperaturbereich mit dem digitalen Zwilling 300 ab. Dabei wird festgestellt, dass der gemeinsame Temperaturbereich zwischen 0 - 20 °C liegt, der dann entsprechend zur Norm bzw. Standardsystemanforderung erhoben wird, da in diesem Temperaturbereich sowohl das cyber-physikalische System 220 als auch das cyber-physikalische System 320 arbeiten kann. Nach der Feststellung des neuen Temperaturbereichs gibt der digitale Zwilling 200 diese geänderte Anforderung an alle verbundenen digitalen Zwillinge 300, 400 weiter, die ihrerseits diese Systemanforderung überprüfen und weiterverwenden.

Da innerhalb eines Systemverbundes die cyber-physikalischen Systeme 220, 320, 420 häufig stark miteinander vernetzt sind und daher eine Änderung einer Systemanforderung für das cyber-physikalische System 220 auch die anderen cyber-physikalischen System 320, 420 betreffen kann, ist in einer Ausführungsform vorgesehen, die Änderungen zu dokumentieren und mit einem Ticketverfahren zu verbinden, um zu verhindern, dass Änderungen mehrfach bearbeitet werden. Jeder Änderung einer Systemanforderung eines cyber-physikalischen Systems 220, 320, 420 wird von dem jeweiligen digitalen Zwilling 200, 300, 400 mit einer eindeutigen Identität versehen wie beispielsweise einem Global Unique Identifier. Sobald eine geänderte Anforderung erstmalig weitergegeben wird, so erhält sie eine eindeutig zuordbare Identität.

Ergibt sich beispielsweise für das cyber-physikalische System 220 eine Änderung, so vergibt der digitale Zwilling 200 eine Identitätskennung und gibt die Identität der Änderung gemeinsam mit der Änderungsmitteilung an die jeweils anderen digitalen Zwillinge 300, 400 weiter. Trifft nun eine solche Änderungsmitteilung bei einem digitalen Zwilling 300, 400 ein, so wird zunächst anhand einer Datenbank, auf die die digitalen Zwillinge 300, 400 zentral zugreifen können oder die lokal bei den digitalen Zwillingen 200, 300 gespeichert ist, überprüft, ob es sich um eine neue Anfrage handelt oder diese Anfrage bereits verarbeitet wurde. Im zweiten Fall wird die Anfrage nicht weiter bearbeitet, im ersten Fall vergleichen die digitalen Zwillinge 300, 400 die Änderung mit ihren Anforderungen und geben die Ergebnisse an den digitalen Zwilling 200 weiter. Es kann ausreichend sein, wenn die Datenbank nur die letzten Anfragen beinhaltet, um somit den Speicherbedarf zu reduzieren. Dies ist jedoch abhängig von der Art und Struktur der cyber-physikalischen Systeme 220, 320, 420 und kann entsprechend angepasst werden.

Stellt der digitale Zwilling 200 für das Anlagenkonzept bzw. ein Teilkonzept des cyber-physikalischen Systems 220 aufgrund der Überprüfung mit den anderen digitalen Zwillingen 300, 400 Inkonsistenzen fest, dann ist die Aufgabe des digitalen Zwillings 200, die Anforderungen des Anlagenkonzepts zu überprüfen und gegebenenfalls über Inkonsistenzen infolge von vorgenommenen Änderungen an dem Anlagenkonzept zu informieren. Inkonsistenzen entstehen dann, wenn Systemanforderungen nicht miteinander in Einklang gebracht werden können und damit Widersprüche entstehen. Beispielsweise arbeitet ein Systemverbund bisher im Niederspannungsbereich, dann kommt ein weiteres cyber-physikalisches System im Hochspannungsbereich hinzu, so dass sich ein Widerspruch ergibt, der aufgelöst werden muss.

Dies kann durch Informieren des verantwortlichen Entwicklungsingenieurs mittels Textnachrichten oder auch durch farbliche Markierung der Inkonsistenzen in dem Engineering-Konzept, wie beispielsweise in der elektrischen Planung, in Automatisierungsdiagrammen oder im Layout geschehen. Solche Unstimmigkeiten und Inkonsistenzen können in der Regel nur durch einen entsprechenden Experten, wie beispielsweise einen Entwicklungsingenieur gelöst werden. Dies kann auch zu einem späteren Zeitpunkt erfolgen, wobei Inkonsistenzen teilweise auch durch weitere Änderungen geklärt werden.

Um die Verteilung der Änderungen an alle verknüpften digitalen Zwillinge 200, 300, 400 sinnvoll einzugrenzen, können Grenzwerte für die Weitergabe von Änderungen statisch hinterlegt oder dynamisch berechnet werden. So kann beispielsweise festgelegt werden, dass eine Temperaturabweichung von 5 Grad keine Änderung darstellt und deswegen keine weitere Information der digitalen Zwillinge 200, 300, 400 erfolgen muss. Oder es kann festgelegt werden, dass eine Weiterverteilung der Änderungen nur dann erfolgen soll, wenn sich die Änderung oberhalb eines festgelegten Grenzwertes bewegt.

Sobald die tatsächlichen cyber-physikalischen Systeme 220, 320, 420 zu einem Systemverbund integriert werden, können generierte Daten ebenfalls den digitalen Zwillingen 200, 300, 400 zugeordnet werden. So können beispielsweise Temperatursensoren ihre aktuell gemessenen Werte an die digitalen Zwillinge 200, 300, 400 weitergeben. Diese Messwerte werden dann mit den Systemanforderungen verglichen. Beim Überschreiten von Grenzwerten kann dies zum Auslösen von Warnungen oder entsprechenden Alarmierungen führen. Des Weiteren können durch die tatsächlich generierten Daten die angenommenen Systemanforderungen überprüft werden.

In einem Systemverbund können unterschiedliche Grenzwerte für einen Messparameter existieren. Zum Beispiel kann es sinnvoll sein, für alle cyber-physikalischen Systeme 220, 320, 420 in einer Produktionshalle einen gemeinsamen Temperaturbereich festzulegen. Erstreckt sich ein Systemverbund jedoch beispielsweise über mehrere Produktionshallen, dann kann es sinnvoll sein, für jede einzelne Produktionshalle einen anderen Temperaturbereich festzulegen, da eine Halle im Gegensatz zu den restlichen Hallen klimatisiert sein könnte. Energie-übertragungsanlagen stellen ein weiteres Beispiel dar, da hier Teile einer Energieübertragungsanlage vor Umwelteinflüssen geschützt sein müssen, dies für andere Teile hingegen nicht notwendig ist.

Es ist auch möglich, dass mehrere Systemverbünde wiederum zu einer höheren Einheit zusammengeschlossen werden, wobei jeder Systemverbund eigene Anforderungen beinhaltet. Diese Anforderungen werden nun wiederum auf der Ebene der höheren Einheit abgeglichen, oder innerhalb einer bestimmten Teilmenge von Systemverbünden. Es sind daher innerhalb der vorliegenden Erfindung unterschiedliche Organisationsprinzipien möglich, wie cyber-physikalische Systeme miteinander verbunden sind und untereinander wechselwirken. So können Systeme bzw. ihre digitalen Zwillinge 200, 300, 400 definierten Gruppen und/oder Klassen zugeordnet werden, die dann bezüglich bestimmter ausgewählter oder aller Anforderungen nur innerhalb dieser Gruppe und/oder Klasse abgeglichen werden. Ob diese Gruppen und/oder Klassen von Systemanforderungen an andere digitale Zwillinge N weitergeleitet werden, hängt davon ab, ob diese digitalen Zwillinge N mit den digitalen Zwillingen 200, 300, 400 verknüpft sind und bezüglich der Systemanforderungen derselben Gruppe/Klasse zugeordnet wurden.

Beispielsweise kann ein System 220 bzw. dessen digitaler Zwilling 200 bezüglich der Anforderungen an die Umgebungstemperatur einer Gruppe A zugeordnet sein, die alle Systeme beinhaltet, die in einer Halle A platziert werden. Dagegen kann dasselbe System 220 bzw. dessen digitaler Zwilling 200 einer weiteren Gruppe B zugeordnet sein, die eine Anforderung "Niederspannung" besitzen. Bezüglich der Anforderung zur Umgebungstemperatur werden die Änderungen nur mit Systemen in der Gruppe A abgestimmt, bezüglich der Anforderungen an die Spannungsebene dagegen mit allen Systemen in der Gruppe B.

Eine Gruppenzuordnung der Systeme kann durch Substrukturen innerhalb der Systemverbünde realisiert werden. Oder es ist möglich, dass Systeme hinsichtlich festgelegter Voraussetzungen unterschiedlichen Gruppen oder Klassen mittels eines Engineeringwerkzeugs zugeordnet werden.

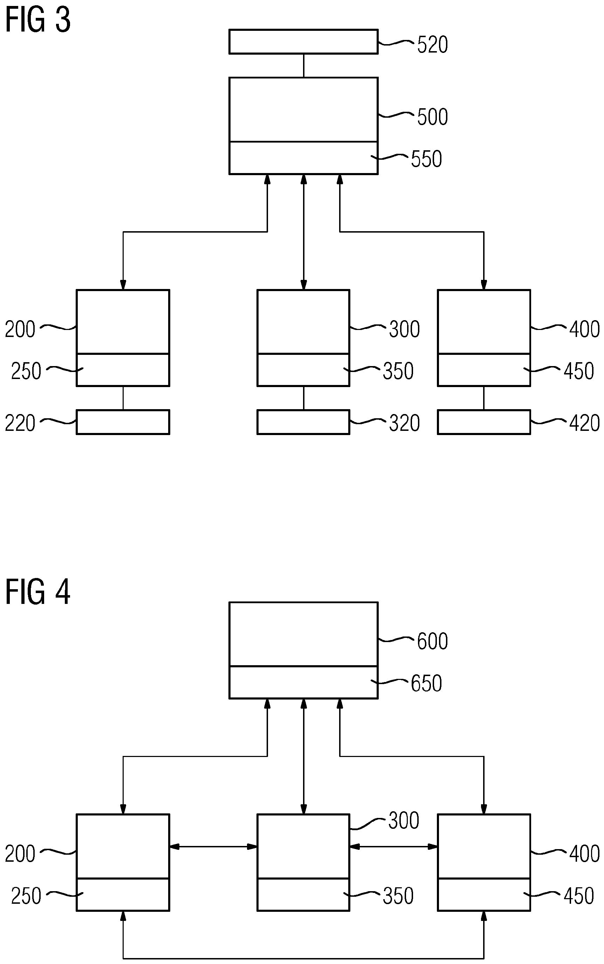

Damit alle geänderten Voraussetzungen im gesamten Systemverbund sicher verteilt werden, gibt es zumindest zwei Möglichkeiten der Realisierung:
Wie in Fig. 3 dargestellt, kann ein zusätzlicher digitaler Zwilling 500 für einen Systemverbund 520 bestehend aus den cyber-physikalischen Systemen 220, 320, 420 vorgesehen sein. Der digitale Zwilling 500 kann auch als eine zentrale Datenbank ausgebildet sein. Der digitale Zwilling 500 enthält die Anforderungen des Systemverbundes 520. Im Rahmen eines Engineering-Projektes ist es auch möglich, dass zunächst die Anforderungen an den Systemverbund 520 festgelegt werden und sich dann im Laufe des Projektes ergibt, welche und wieviel andere cyber-physikalische Systeme 220, 320, 420 in den Systemverbund 520 integriert werden sollen. Der digitale Zwilling 500 des Systemverbundes 520 kann zum Management des Systemverbundes 520 genutzt werden und dient der Integration der angeschlossenen cyber-physikalischen System 320, 420, 520. Insbesondere kann der digitale Zwilling 500 Konflikte bei der Integration der cyber-physikalischen Systemen 220, 320, 420 mit einer zentralen Anforderung zu identifizieren.

Bei jeder Integration eines digitalen Zwillings 200, 300, 400 in den Systemverbund 520 ist der digitale Zwilling 500 des Systemverbundes 520 zu informieren, wobei eine solche Information auch automatisch erfolgen kann beim Andocken eines digitalen Zwillings 200, 300, 400 an den digitalen Zwilling 500 des Systemverbundes 520. Des Weiteren werden gemäß der vorliegenden Erfindung alle weiteren, bereits mit dem digitalen Zwilling 500 des Systemverbundes verknüpften digitalen Zwillinge 200, 300, 400 informiert, um eventuelle Inkonsistenzen aufzudecken.

So kann sich ergeben, dass der digitale Zwilling 200 einen gewählten Temperaturbereich des Systemverbundes 520 erfüllt, während diese Anforderung von den digitalen Zwillingen 300, 400 nicht erfüllt wird.

In dem bereits in Fig. 1 dargestellten Ausführungsbeispiel der Erfindung, handelt es sich um vollständig autonom agierende digitale Zwillinge 200, 300, 400, da ein digitaler Zwilling für einen Systemverbund bestehend aus den cyber-physikalischen Systemen 220, 320, 420 nicht vorgesehen ist. In dieser Variante hat jeder digitale Zwilling 200, 300, 400 ein möglichst umfassendes Bild der Voraussetzungen des Systemverbunds, da jeder digitale Zwilling 200, 300, 400 aus allen bisher angefragten Anforderungen die Anforderungen des Systemverbunds ableitet und speichert.

Zum Beispiel wäre im Falle der Erdbebensicherheit der Systemverbund so lange erdbebensicher bis das erste nicht erdbebensichere cyber-physikalische System 400 hinzukommt. Im Falle der Temperaturbereiche wäre der Temperaturbereich des Systemverbundes die Schnittmenge der Temperaturbereiche aller cyber-physikalischer Systeme 200, 300, 400 im Systemverbund.

Wie in Fig. 4 dargestellt, werden im Fall einer neuen Verknüpfung eines neuen digitalen Zwillings 600 mit den bereits vorhandenen digitalen Zwillingen 200, 300, 400 alle direkt und indirekt verknüpften digitalen Zwillinge 200, 300, 400 miteinander abgeglichen. Das Ergebnis eines solchen Abgleichs ist damit die Schnittmenge der Systemanforderungen des Systemverbundes bestehend aus den cyber-physikalischen Systemen 220, 320, 420, 620.

Mittels einer Softwareapplikation, die in einer zentralen Überwachungseinrichtung oder dezentral installiert sein kann, können die ermittelten Systemanforderungen analysiert und graphisch dargestellt werden. Es kann beispielsweise für den Temperaturbereich eine Analyse durchgeführt werden, welche diejenigen Systeme anzeigt, die nur für einen eingeschränkten Temperaturbereich geeignet sind. Aufgrund dieser Information können dann Anpassungen der jeweiligen cyber-physikalischen Systeme vorgenommen werden oder es werden Anpassungen in der Umgebung wie eine Klimatisierung vorgenommen.

Des Weiteren ist es vorteilhaft, eine regelmäßige Überprüfung eines Systemverbundes 500 mittels der digitalen Zwillinge 200, 300, 400 vorzunehmen, um beispielsweise mögliche Ausfälle im Systemverbund 500 oder verschleißbedingte Änderungen zu erkennen.

Des Weiteren kann vorgesehen sein, einen oder mehrere digitaler Zwillinge 200, 300, 400 wieder zu entfernen, beispielsweise den Zwilling 200. Dann greifen die anderen verbleibenden digitalen Zwillinge 300, 400 wieder auf ihre ursprünglichen Systemanforderungen zurück, die vor dem Zusammenschluss mit dem oder den nun entfernten digitalen Zwilling 200 gültig waren. Dies bedeutet, dass ein digitaler Zwilling 200, 300, 400 seine Systemanforderungen bei einem Zusammenschluss mit anderen digitalen Zwillingen 200, 300, 400 zwar anpasst, aber seine eigenen ursprünglichen Systemanforderungen weiterhin beibehält. Für den Fall, dass ein digitaler Zwilling 200 entfernt wird, stehen dann die ursprünglichen Systemanforderungen wieder zur Verfügung, um die Systemanforderungen für einen neuen Systemverbund ohne diesen digitalen Zwilling 200 zu bestimmen. Das Entfernen eines digitalen Zwillings 200 wird an die anderen verbleibenden Zwillinge 300, 400 beispielsweise durch eine Abmeldung kommuniziert mit entsprechenden Kommunikationsprotokollen.

Wenn ein digitaler Zwilling 200 entfernt wird, beispielsweise durch einen Systemoperator, führen die verbleibenden digitalen Zwillinge 300, 400 einen erneuten Abgleich durch und überprüfen die bisher vorliegenden Systemanforderungen, ob diese bestehen bleiben können oder eine Änderung notwendig ist.

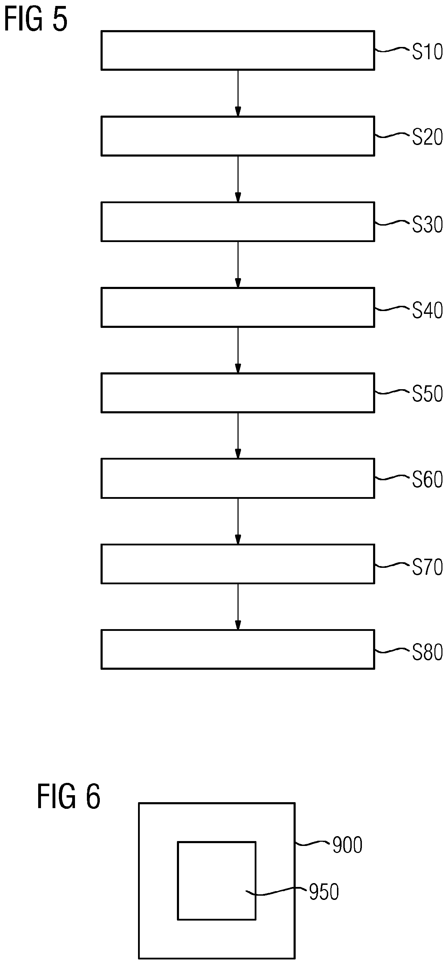

Fig. 5 zeigt ein Ablaufdiagramm eines erfindungsgemäßen Verfahrens zur Überprüfung von Systemanforderungen von cyber-physikalischen Systemen 220, 320, 420.

Im Schritt S10 wird ein digitaler Zwilling 200, 300, 400 für jeweils ein cyber-physikalisches System 220, 320, 420 erstellt.

Im Schritt S20 werden Systemanforderungen für jedes der cyber-physikalischen Systeme 220, 320, 420 festgelegt.

Im Schritt S30 werden die Systemanforderungen eines cyber-physikalischen Systems 220, 320, 420 in dem digitalen Zwilling 200, 300, 400, der dem jeweiligen cyber-physikalischen System zugeordnet ist, direkt und/oder indirekt gespeichert.

Im Schritt S40 werden zumindest zwei oder mehr digitale Zwillinge 200, 300, 400 miteinander verknüpft.

Im Schritt S50 kommunizieren die miteinander verknüpften digitalen Zwillinge 200, 300, 400 jeweils paarweise miteinander und tauschen ihre Systemanforderungen zumindest teilweise gegenseitig aus.

Im Schritt S60 vergleichen die digitalen Zwillinge 200, 300, 400 jeweils ihre gespeicherten Systemanforderungen mit den erhaltenen Systemanforderungen.

Im Schritt S70 passen die digitalen Zwillinge 200, 300, 400 ihre Systemanforderungen aufgrund des durchgeführten Vergleichs mit den erhaltenen Systemanforderungen an und können diese als neue Systemanforderung festlegen.

Im Schritt S80 teilen die digitalen Zwillinge 200, 300, 400 ihre neu festgelegten Systemanforderungen den anderen digitalen Zwillingen 200, 300, 400 mit.

Fig. 6 stellt schematisch ein Computerprogrammprodukt 900 dar, das einen und/der mehrere ausführbare Computercodes 950 enthält zur Ausführung des Verfahrens nach dem ersten Aspekt der Erfindung.

Gemäß der vorliegenden Erfindung wird die Schlüssigkeit und Konsistenz einer Engineering-Lösung bei Änderungen von bedeutsamen Systemanforderungen aufgrund vordefinierter oder sich dynamisch ändernder Werte kontinuierlich durch den Abgleich von miteinander verknüpften digitalen Zwillingen 200, 300, 400 sichergestellt. Voraussetzung ist die Erstellung eines digitalen Zwillings 200, 300, 400 für jedes cyber-physikalische System 220, 320, 420, in dem die Anforderungen für das jeweilige cyber-physikalische System 220, 320, 420 festgehalten wird.

Die Auswahl der Systemanforderungen, die als bedeutsam erachtet werden, wird vorzugsweise bereichsübergreifend festgelegt. Dabei können sowohl übergreifende als auch bereichsspezifische Systemanforderungen definiert werden.

Durch die vorliegende Erfindung werden wesentliche Anforderungen eines Anlagenkonzepts für einen Systemverbund bestehend aus mehreren cyber-physikalischen Systemen 220, 320, 420 kontinuierlich überprüft und können jederzeit transparent angezeigt werden. Zudem können Auswirkungen von Änderungen eines cyber-physikalischen Systems auf anderer cyber-physikalische Systeme 220, 320, 420 sofort sichtbar gemacht werden, wodurch bei komplexen Systemverbünden Zeit und Kosten eingespart werden können.

## Patentansprüche

1. Verfahren zum Überprüfen von Systemanforderungen von cyber-physikalischen Systemen (220, 320, 420) in einem Systemverbund (550), die Systemanforderungen umfassend Anforderungen der cyber-physikalischen Systeme (220, 320, 420) an deren Umgebung und/oder Randbedingungen zur Nutzung der cyber-physikalischen Systeme (220, 320, 420), umfassend:
- Erstellen (S10) eines digitalen Zwillings (200, 300, 400) für zumindest jeweils ein cyber-physikalisches System (220, 320, 420), wobei der digitale Zwilling (200, 300, 400) einen Engineering-Anteil umfasst, der für ein Engineering der cyber-physikalischen Systeme (220, 320, 420) und den Zusammenschluss der cyber-physikalischen Systeme (220, 320, 420) zu einem Systemverbund (550) verwendet wird und wobei der Engineering-Anteil alle Engineering-Informationen die das cyberphysikalische System (220, 320, 420) betreffen, einschließlich einer Dokumentation, umfasst, um das cyber-physikalische System (220, 320, 420) in einem Systemverbund zu verwenden;
- Festlegen (S20) von Systemanforderungen für jedes der cyber-physikalischen Systeme (220, 320, 420);
- Speichern (S30) der Systemanforderungen der cyber-physikalischen Systeme (220, 320, 420) direkt und/oder indirekt in denjenigen digitalen Zwillingen (200, 300, 400), die dem cyber-physikalischen System (220, 320, 420) jeweils zugeordnet sind;
- Verknüpfen (S40) von zumindest zwei oder mehr digitalen Zwillingen (200, 300, 400);
- wobei die verknüpften digitalen Zwillinge (200, 300, 400) jeweils paarweise miteinander kommunizieren und gegenseitig ihre Systemanforderungen zumindest teilweise austauschen (S50);
- wobei die digitalen Zwillinge (200, 300, 400) die gespeicherten Systemanforderungen mit den erhaltenen Systemanforderungen vergleichen (S60);
- wobei die digitalen Zwillinge (200, 300, 400) ihre Systemanforderungen aufgrund des durchgeführten Vergleichs mit den erhaltenen Systemanforderungen anpassen und diese als neue Systemanforderung festlegen können (S70);
- wobei die digitalen Zwillinge (200, 300, 400) ihre Systemanforderungen anpassen, falls einer der digitalen Zwillinge eingeschränktere Systemanforderungen aufweist;
- wobei die digitalen Zwillinge (200, 300, 440) ihre eigenen Systemanforderungen für einen Abgleich an die jeweils verknüpften digitalen Zwillinge (200, 300, 440) weitergeben, falls die Systemanforderungen des digitalen Zwillings selbst eingeschränkter sind;
- wobei die digitalen Zwillinge (200, 300, 440) ihre Systemanforderungen bei einem Zusammenschluss mit anderen digitalen Zwillingen anpassen und die eigene ursprüngliche Systemanforderung beibehalten;
- wobei die digitalen Zwillinge (200, 300, 400) ihre neu festgelegten Systemanforderungen den anderen digitalen Zwillingen (200, 300, 400) mitteilen (S80), und
- wobei die ursprünglichen Systemanforderungen der digitalen Zwillinge (200, 300, 400) gespeichert sind und beim Entfernen eines digitalen Zwillings (200) aus einem Systemverbund (550) die verbleibenden digitalen Zwillinge (300, 400) auf ihre ursprünglichen Systemanforderungen zurückgreifen können.

2. Verfahren nach Anspruch 1, **dadurch gekennzeichnet, dass** ein digitaler Zwilling (500) für einen Systemverbund (500) aus den cyber-physikalischen Systemen (220, 320, 420) erstellt wird und die digitalen Zwillinge (200, 300, 400) der cyber-physikalischen Systeme (220, 320, 420) mit dem digitalen Zwilling (500) für den Systemverbund (550) verknüpft werden.

3. Verfahren nach einem der vorangehenden Ansprüche, **dadurch gekennzeichnet, dass** der digitale Zwilling (200), bei dessen zugeordnetem cyber-physikalischem System (220) eine Änderung einer Systemanforderung auftritt, diese Änderung den anderen mit ihm verknüpften digitalen Zwillingen (300, 400) mitteilt und diese digitalen Zwillinge (300, 400) die geänderte Systemanforderung mit den bisher vorliegenden Systemanforderungen vergleichen.

4. Verfahren nach Anspruch 3, **dadurch gekennzeichnet, dass** jede Änderung einer Systemanforderung mit einer Identitätskennung versehen wird.

5. Verfahren nach einem der vorangehenden Ansprüche, **dadurch gekennzeichnet, dass** die digitalen Zwillinge (200, 300, 400) über eine Kommunikationsschnittstelle jeweils mit den anderen digitalen Zwillingen (200, 300, 400) kommunizieren.

6. System (100) angepasst zur Durchführung des Verfahrens nach Anspruch 1 zum Uberprüfen von Systemanforderungen von cyber-physikalischen Systemen (220, 320, 420) in einem Systemverbund (550), die Systemanforderungen umfassend Anforderungen der cyber-physikalischen Systeme (220, 320, 420) an deren Umgebung und/oder Randbedingungen zur Nutzung der cyber-physikalischen Systeme (220, 320, 420); wobei ein digitaler Zwilling (200, 300, 400) für jeweils ein cyber-physikalisches System (220, 320, 420) vorgesehen ist und Systemanforderungen für jedes der cyber-physikalischen Systeme (220, 320, 420) festgelegt sind; wobei der digitale Zwilling (200, 300, 400) einen Engineering-Anteil umfasst, der für ein Engineering der cyber-physikalischen Systeme (220, 320, 420) und den Zusammenschluss der cyber-physikalischen Systeme (220, 320, 420) zu einem Systemverbund (550) verwendet wird und wobei der Engineering-Anteil alle Engineering-Informationen, die das cyberphysikalische System (220, 320, 420) betreffen, einschließlich einer Dokumentation, umfasst, um das cyber-physikalische System (220, 320, 420) in einem Systemverbund zu verwenden, wobei der jeweilige digitale Zwilling (200, 300, 400), der dem jeweiligen cyber-physikalischen System (220, 320, 420) zugeordnet ist, ausgebildet ist, die Systemanforderungen des cyber-physikalischen Systems (220, 320, 420) direkt und/oder indirekt zu speichern; wobei zumindest zwei oder mehr digitalen Zwillinge (200, 300, 400) ausgebildet sind, miteinander verknüpft zu werden und jeweils paarweise miteinander zu kommunizieren und gegenseitig ihre Systemanforderungen zumindest teilweise auszutauschen; wobei die digitalen Zwillinge (200, 300, 400) ausgebildet sind, die gespeicherten Systemanforderungen mit den erhaltenen Systemanforderungen zu vergleichen und ihre Systemanforderungen aufgrund des durchgeführten Vergleichs mit den erhaltenen Systemanforderungen anzupassen und als neue Systemanforderung festlegen können; wobei die digitalen Zwillinge (200, 300, 400) ausgebildet sind, ihre Systemanforderungen anzupassen, falls einer der digitalen Zwillinge eingeschränkte Systemanforderungen aufweist; wobei die digitalen Zwillinge (200, 300, 400) ausgebildet sind, ihre Systemanforderungen für einen Abgleich an die jeweils verknüpften digitalen Zwillinge (200, 300, 400) weitergeben, falls die Systemanforderungen des digitalen Zwillings selbst eingeschränkter sind; wobei die digitalen Zwillinge (200, 300, 400) ihre Systemanforderungen bei einem Zusammenschluss mit anderen digitalen Zwillingen anpassen und die eigene ursprüngliche Systemanforderung beibehalten; wobei die digitalen Zwillinge (200, 300, 400) ausgebildet sind, ihre neu festgelegten Systemanforderungen den anderen digitalen Zwillingen (200, 300, 400) mitzuteilen; und wobei die ursprünglichen Systemanforderungen der digitalen Zwillinge (200, 300, 400) gespeichert sind und beim Entfernen eines digitalen Zwillings (200) aus einem Systemverbund (550) die verbleibenden digitalen Zwillinge (300, 400) auf ihre ursprünglichen Systemanforderungen zurückgreifen können.

7. System (100) nach Anspruch 6, **dadurch gekennzeichnet, dass** ein digitaler Zwilling (500) für einen Systemverbund (550) der cyber-physikalischen System (220, 320, 420) vorgesehen ist und die digitalen Zwillinge (200, 300, 400) der cyber-physikalischen Systeme (220, 320, 420) mit dem digitalen Zwilling (500) für den Systemverbund (550) verknüpft sind.

8. System (100) nach einem der vorangehenden Ansprüche 6 oder 7, **dadurch gekennzeichnet, dass** der digitale Zwilling (200), bei dessen zugeordnetem cyber-physikalischem System (220) eine Änderung einer Systemanforderung auftritt, ausgebildet ist, diese Änderung den anderen mit ihm verknüpften Zwillingen (300, 400) mitzuteilen und diese Zwillinge (300, 400) ausgebildet sind, die geänderte Systemanforderung mit den bisher vorliegenden Systemanforderungen zu vergleichen.

9. System (100) nach Anspruch 8, **dadurch gekennzeichnet, dass** jede Änderung einer Systemanforderung mit einer Identitätskennung versehen ist.

10. System (100) nach einem der vorangehenden Ansprüche 6-9, **dadurch gekennzeichnet, dass** die digitalen Zwillinge (200, 300, 400) eine Kommunikationsschnittstelle zur Kommunikation mit anderen digitalen Zwillingen (200, 300, 400) aufweisen.

11. Computerprogrammprodukt (900), das einen und/der mehrere ausführbare Computercodes (950) enthält zur Ausführung des Verfahrens nach einem oder mehreren der Ansprüche 1 bis 5.

## Claims

1. Method for checking system requirements of cyber-physical systems (220, 320, 420) in a composite system (550), the system requirements comprising requirements of the cyber-physical systems (220, 320, 420) imposed on their environment and/or boundary conditions for using the cyber-physical systems (220, 320, 420), comprising:
- creating (S10) a digital twin (200, 300, 400) for at least one cyber-physical system (220, 320, 420) in each case, wherein the digital twin (200, 300, 400) comprises an engineering part which is used to engineer the cyber-physical systems (220, 320, 420) and to combine the cyber-physical systems (220, 320, 420) to form a composite system (550), and wherein the engineering part comprises all engineering information relating to the cyber-physical system (220, 320, 420), including documentation, in order to use the cyber-physical system (220, 320, 420) in a composite system;
- stipulating (S20) system requirements for each of the cyber-physical systems (220, 320, 420);
- storing (S30) the system requirements of the cyber-physical systems (220, 320, 420) directly and/or indirectly in those digital twins (200, 300, 400) which are each assigned to the cyber-physical system (220, 320, 420);
- linking (S40) at least two or more digital twins (200, 300, 400);
- wherein the linked digital twins (200, 300, 400) each communicate in pairs with one another and at least partially interchange (S50) their system requirements with each other;
- wherein the digital twins (200, 300, 400) compare (S60) the stored system requirements with the received system requirements;
- wherein the digital twins (200, 300, 400) adapt their system requirements on the basis of the comparison carried out with the received system requirements and can stipulate (S70) these as a new system requirement;
- wherein the digital twins (200, 300, 400) adapt their system requirements if one of the digital twins has restricted system requirements;
- wherein the digital twins (200, 300, 400) forward their own system requirements to the respectively linked digital twins (200, 300, 400) for a comparison if the system requirements of the digital twin itself are more restricted;
- wherein the digital twins (200, 300, 400) adapt their system requirements when combined with other digital twins and retain their own original system requirement;
- wherein the digital twins (200, 300, 400) communicate (S80) their newly stipulated system requirements to the other digital twins (200, 300, 400), and
- wherein the original system requirements of the digital twins (200, 300, 400) are stored and, if a digital twin (200) is removed from a composite system (550), the remaining digital twins (300, 400) can resort to their original system requirements.

2. Method according to Claim 1, **characterized in that** a digital twin (500) is created for a composite system (500) of the cyber-physical systems (220, 320, 420), and the digital twins (200, 300, 400) of the cyber-physical systems (220, 320, 420) are linked to the digital twin (500) for the composite system (550).

3. Method according to one of the preceding claims, **characterized in that** the digital twin (200), in the assigned cyber-physical system (220) of which a change in a system requirement occurs, communicates this change to the other digital twins (300, 400) linked to it, and these digital twins (300, 400) compare the changed system requirement with the previous system requirements.

4. Method according to Claim 3, **characterized in that** each change in a system requirement is provided with an identifier.

5. Method according to one of the preceding claims, **characterized in that** the digital twins (200, 300, 400) each communicate with the other digital twins (200, 300, 400) via a communication interface.

6. System (100) adapted to carry out the method according to Claim 1 for checking system requirements of cyber-physical systems (220, 320, 420) in a composite system (550), the system requirements comprising requirements of the cyber-physical systems (220, 320, 420) imposed on their environment and/or boundary conditions for using the cyber-physical systems (220, 320, 420); wherein a digital twin (200, 300, 400) is provided for a cyber-physical system (220, 320, 420) in each case and system requirements are stipulated for each of the cyber-physical systems (220, 320, 420); wherein the digital twin (200, 300, 400) comprises an engineering part which is used to engineer the cyber-physical systems (220, 320, 420) and to combine the cyber-physical systems (220, 320, 420) to form a composite system (550), and wherein the engineering part comprises all engineering information relating to the cyber-physical system (220, 320, 420), including documentation, in order to use the cyber-physical system (220, 320, 420) in a composite system, wherein the respective digital twin (200, 300, 400) assigned to the respective cyber-physical system (220, 320, 420) is designed to store the system requirements of the cyber-physical system (220, 320, 420) directly and/or indirectly; wherein at least two or more digital twins (200, 300, 400) are designed to be linked to one another and to each communicate in pairs with one another and to at least partially interchange their system requirements with each other; wherein the digital twins (200, 300, 400) are designed to compare the stored system requirements with the received system requirements and to adapt their system requirements on the basis of the comparison carried out with the received system requirements and to be able to stipulate these as a new system requirement; wherein the digital twins (200, 300, 400) are designed to adapt their system requirements if one of the digital twins has restricted system requirements; wherein the digital twins (200, 300, 400) are designed to forward their system requirements to the respectively linked digital twins (200, 300, 400) for a comparison if the system requirements of the digital twin itself are more restricted; wherein the digital twins (200, 300, 400) adapt their system requirements when combined with other digital twins and retain their own original system requirement; wherein the digital twins (200, 300, 400) are designed to communicate their newly stipulated system requirements to the other digital twins (200, 300, 400); and wherein the original system requirements of the digital twins (200, 300, 400) are stored and, if a digital twin (200) is removed from a composite system (550), the remaining digital twins (300, 400) can resort to their original system requirements.

7. System (100) according to Claim 6, **characterized in that** a digital twin (500) is provided for a composite system (550) of the cyber-physical systems (220, 320, 420), and the digital twins (200, 300, 400) of the cyber-physical systems (220, 320, 420) are linked to the digital twin (500) for the composite system (550).

8. System (100) according to either of the preceding Claims 6 and 7, **characterized in that** the digital twin (200), in the assigned cyber-physical system (220) of which a change in a system requirement occurs, is designed to communicate this change to the other twins (300, 400) linked to it, and these twins (300, 400) are designed to compare the changed system requirement with the previous system requirements.

9. System (100) according to Claim 8, **characterized in that** each change in a system requirement is provided with an identifier.

10. System (100) according to one of the preceding Claims 6-9, **characterized in that** the digital twins (200, 300, 400) have a communication interface for communicating with other digital twins (200, 300, 400).

11. Computer program product (900) which contains one and/or more executable computer codes (950) for carrying out the method according to one or more of Claims 1 to 5.

## Revendications

1. Procédé de vérification d'exigences systèmes de systèmes cyberphysiques (220, 320, 420) dans un système intégré (550), les exigences systèmes comprenant des exigences des systèmes cyberphysiques (220, 320, 420) concernant leur environnement et/ou des contraintes pour l'utilisation des systèmes cyberphysiques (220, 320, 420), comprenant :
- la création (S10) d'un jumeau numérique (200, 300, 400) pour au moins respectivement un système cyberphysique (220, 320, 420), dans lequel le jumeau numérique (200, 300, 400) comprend une partie d'ingénierie, qui est utilisée pour une ingénierie des systèmes cyberphysiques (220, 320, 420) et le regroupement des systèmes cyberphysiques (220, 320, 420) en un système intégré (550) et dans lequel la partie d'ingénierie comprend toutes les informations d'ingénierie qui concernent le système cyberphysique (220, 320, 420), y compris une documentation permettant d'utiliser le système cyberphysique (220, 320, 420) dans un système intégré ;
- détermination (S20) d'exigences systèmes pour chacun des systèmes cyberphysiques (220, 320, 420) ;
- enregistrement (S30) des exigences systèmes des systèmes cyberphysiques (220, 320, 420) directement et/ou indirectement dans les jumeaux numériques (200, 300, 400) qui correspondent au système cyberphysique (220, 320, 420) respectivement associés ;
- combinaison (S40) d'au moins deux jumeaux numériques (200, 300, 400) ou plus ;
- dans lequel les jumeaux numériques (200, 300, 400) combinés communiquent respectivement entre eux par paires et échangent mutuellement au moins partiellement leurs exigences systèmes (S50) ;
- dans lequel les jumeaux numériques (200, 300, 400) comparent les exigences systèmes enregistrées avec les exigences systèmes obtenues (S60) ;
- dans lequel les jumeaux numériques (200, 300, 400) adaptent leurs exigences systèmes sur la base de la comparaison effectuée avec les exigences systèmes obtenues et peuvent définir celles-ci comme de nouvelles exigences systèmes (S70) ;
- dans lequel les jumeaux numériques (200, 300, 400) adaptent leurs exigences systèmes si un des jumeaux numériques présente des exigences systèmes restreintes ;
- dans lequel les jumeaux numériques (200, 300, 440) transmettent leurs propres exigences systèmes pour une comparaison aux jumeaux numériques (200, 300, 440) combinés si les exigences systèmes du jumeau numérique lui-même sont plus restreintes ;
- dans lequel les jumeaux numériques (200, 300, 440) adaptent leurs exigences systèmes lors d'un regroupement avec d'autres jumeaux numériques et conservent leur propre exigence système initiale ;
- dans lequel les jumeaux numériques (200, 300, 400) notifient aux autres jumeaux numériques (200, 300, 400) leurs exigences systèmes nouvellement déterminées (S80) et
- dans lequel les exigences systèmes initiales des jumeaux numériques (200, 300, 400) sont enregistrées et, lors du retrait d'un jumeau numérique (200) d'un système intégré (550), les jumeaux numériques (300, 400) restants peuvent revenir à leurs exigences systèmes initiales.

2. Procédé selon la revendication 1, **caractérisé en ce qu'**un jumeau numérique (500) pour un système intégré (500) est créé à partir des systèmes cyberphysiques (220, 320, 420) et les jumeaux numériques (200, 300, 400) des systèmes cyberphysiques (220, 320, 420) sont combinés avec le jumeau numérique (500) pour le système intégré (550).

3. Procédé selon l'une des revendications précédentes, **caractérisé en ce que** le jumeau numérique (200) au niveau système cyberphysique (220) duquel survient une modification d'une exigence système, cette modification est notifiée aux autres jumeaux numériques (300, 400) combinés avec lui et ces jumeaux numériques (300, 400) comparent les exigences systèmes modifiées avec les exigences systèmes existant jusqu'à présent.

4. Procédé selon la revendication 3, **caractérisé en ce que** chaque modification d'une exigence système est munie d'un identifiant.

5. Procédé selon l'une des revendications précédentes, **caractérisé en ce que** les jumeaux numériques (200, 300, 400) communiquent respectivement avec les autres jumeaux numériques (200, 300, 400) par l'intermédiaire d'une interface de communication.

6. Système (100) conçu pour l'exécution du procédé selon la revendication 1 pour la vérification d'exigences systèmes de systèmes cyberphysiques (220, 320, 420) dans un système intégré (550), les exigences systèmes comprenant des exigences des systèmes cyberphysiques (220, 320, 420) concernant leur environnement et/ou des contraintes pour l'utilisation des systèmes cyberphysiques (220, 320, 420) ; dans lequel un jumeau numérique (200, 300, 400) pour respectivement un système cyberphysique (220, 320, 420) est prévu et des exigences systèmes sont déterminées pour chacun des systèmes cyberphysiques (220, 320, 420) ; dans lequel le jumeau numérique (200, 300, 400) comprend une partie d'ingénierie qui est utilisée pour une ingénierie des systèmes cyberphysiques (220, 320, 420) et le regroupement des systèmes cyberphysiques (220, 320, 420) en un système intégré (550) et dans lequel la partie d'ingénierie comprend toutes les informations d'ingénierie qui concernent le système cyberphysique (220, 320, 420), y compris une documentation, permettant d'utiliser le système cyberphysique (220, 320, 420) dans un système intégré, dans lequel le jumeau numérique (200, 300, 400) respectif, qui correspond au système cyberphysique (220, 320, 420) respectif, est conçu pour enregistrer les exigences systèmes du système cyberphysique (220, 320, 420) directement et/ou indirectement ; dans lequel au moins deux jumeaux numériques (200, 300, 400) ou plus sont conçus pour être combinés entre eux et pour communiquer respectivement entre eux par paires et échanger mutuellement au moins partiellement leurs exigences systèmes ; dans lequel les jumeaux numériques (200, 300, 400) sont conçus pour comparer les exigences systèmes enregistrées avec les exigences systèmes obtenues et pour adapter leurs exigences systèmes sur la base de la comparaison effectuée avec les exigences systèmes obtenues et les déterminer comme nouvelles exigences systèmes ; dans lequel les jumeaux numériques (200, 300, 400) sont conçus pour adapter leurs exigences systèmes si un des jumeaux numériques présente des exigences systèmes restreintes ; dans lequel les jumeaux numériques (200, 300, 400) sont conçus pour transmettre leurs exigences systèmes, pour une comparaison, aux jumeaux numériques (200, 300, 400) respectivement combinés si les exigences systèmes du jumeau numérique lui-même sont plus restreintes ; dans lequel les jumeaux numériques (200, 300, 400) adaptent leurs exigences systèmes lors d'un regroupement avec d'autres jumeaux numériques et conservent leurs propres exigences systèmes initiales ; dans lequel les jumeaux numériques (200, 300, 400) sont conçus pour notifier leurs exigences systèmes nouvellement déterminées aux autres jumeaux numériques (200, 300, 400) ; et dans lequel les exigences systèmes initiales des jumeaux numériques (200, 300, 400) sont enregistrées et, lors du retrait d'un jumeau numérique (200) d'un système intégré (550), les jumeaux numériques (300, 400) restants peuvent revenir à leurs exigences systèmes initiales.

7. Système (100) selon la revendication 6, **caractérisé en ce qu'**un jumeau numérique (500) est prévu pour un système intégré (550) des systèmes cyberphysiques (220, 320, 420) et les jumeaux numériques (200, 300, 400) des systèmes cyberphysiques (220, 320, 420) sont combinés avec le jumeau numérique (500) pour le système intégré (550).

8. Système (100) selon l'une des revendications précédentes 6 ou 7, **caractérisé en ce que** le jumeau numérique (200), au niveau du système cyberphysique (220) duquel survient une modification d'une exigence système, est conçu pour notifier cette modification aux autres jumeaux (300, 400) combinés avec lui et ces jumeaux (300, 400) sont conçus pour comparer les exigences systèmes modifiées avec les exigences systèmes existant jusqu'à présent.

9. Système (100) selon la revendication 8, **caractérisé en ce que** chaque modification d'une exigence système est munie d'un identifiant.

10. Système (100) selon l'une des revendications précédentes 6 à 9, **caractérisé en ce que** les jumeaux numériques (200, 300, 400) comprennent une interface de communication pour la communication avec d'autres jumeaux numériques (200, 300, 400) .

11. Produit de programme informatique (900) qui contient un ou plusieurs codes informatiques exécutables (950) pour l'exécution du procédé selon l'une ou plusieurs des revendications 1 à 5.
